**Europäisches Patentamt**

**European Patent Office**

**Office européen des brevets**

(11) Veröffentlichungsnummer: **0 041 259**
**B1**

(12) **EUROPÄISCHE PATENTSCHRIFT**

(45) Veröffentlichungstag der Patentschrift:
**30.11.83**

(21) Anmeldenummer: **81104144.1**

(22) Anmeldetag: **29.05.81**

(51) Int. Cl.³: **B 01 J 4/00**, B 01 J 8/00,
G 21 C 3/62

(54) Wirbelschichtofen sowie Verfahren zur Entleerung desselben.

(30) Priorität: **03.06.80 DE 3021037**

(43) Veröffentlichungstag der Anmeldung:
**09.12.81 Patentblatt 81/49**

(45) Bekanntmachung des Hinweises auf die Patenterteilung:
**30.11.83 Patentblatt 83/48**

(84) Benannte Vertragsstaaten:
**BE FR GB IT**

(56) Entgegenhaltungen:
**DE - B - 2 611 844**
**FR - A - 2 366 870**

(73) Patentinhaber: **Kernforschungsanlage Jülich
Gesellschaft mit beschränkter Haftung, Postfach 1913,
D-5170 Jülich (DE)**

(72) Erfinder: **Barnert, Eike, Dr. Dipl.-Ing., Röntgenstrasse 13,
D-5170 Jülich (DE)**
Erfinder: **Schmitz, Heinz, Dipl.-Ing.,
Damaschkestrasse 24, D-5100 Aachen (DE)**

(74) Vertreter: **Paul, Dieter-Alfred, Dipl.-Ing., Erftstrasse 82,
D-4040 Neuss 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Wirbelschichtofen sowie Verfahren zur Entleerung desselben

Die Erfindung betrifft einen Wirbelschichtofen für die Beschichtung von Brennstoffkernen für Kernreaktoren, insbesondere von HTR-Brennstoffkernen, mit einem Reaktionsrohr zur Aufnahme der Kerne, dessen unteres Ende wenigstens eine Blendenöffnung aufweist, sowie mit einem sich nach unten anschließenden Außenrohr und wenigstens einem in diesem unterhalb jeder Blendenöffnung angeordneten, axial verschiebbaren Innenrohr, wobei in dem Zwischenraum zwischen Außenrohr und Innenrohr(en) eine poröse Platte angeordnet ist sowie der Zwischenraum für die Zuführung eines Trägergases und das Innenrohr für die Zuführung eines Beschichtungsgases vorgesehen ist.

Brennstoffkerne für Kernreaktoren werden mit einem geeigneten Stoff beschichtet, um das Austreten von Spaltprodukten zu verhindern. Dies geschieht in einem Wirbelschichtofen bei Reaktionstemperaturen zwischen 1000 und 2200°C, indem den Kernen ein Gemisch aus einem Trägergas, wie Argon, Helium, Wasserstoff, Stickstoff, Kohlenmonoxid oder dergleichen, und einem zur Pyrolyse geeigneten Beschichtungsgas, wie Methan, Acetylen, Propan, Propylen, Chlormethylsilan, Molybdän-V-Chlorid oder dergleichen, zugeführt wird. Das Trägergas dient dabei der Herabsetzung der Konzentration des Beschichtungsgases und erzeugt zudem eine Durchwirbelung der Kerne in dem Ofen.

Ein solcher Wirbelschichtofen ist in der DE-B-2 611 844 beschrieben. Die Kerne werden dort von oben in ein Reaktionsrohr eingefüllt, das unten eine Blendenöffnung aufweist. In diese Blendenöffnung wird das Gemisch aus Beschichtungs- und Trägergas mit einer solchen Geschwindigkeit eingeblasen, daß die Kerne nicht durch die Blendenöffnung nach unten fallen und darüber hinaus in einer zirkulierenden Bewegung gehalten werden. Die Zufuhr des Beschichtungsgases geschieht über ein unterhalb im Abstand zur Blendenöffnung mündendes Innenrohr, das zur Einstellung des optimalen Abstandes zum Reaktionsrohr axial verschieblich ist. Für die Zufuhr des Trägergases dient ein vom Innenrohr und von einem dieses konzentrisch umgebendes Außenrohr gebildeter Zwischenraum. In diesen Zwischenraum ist eine poröse Platte eingesetzt, die eine Vergleichmäßigung des Geschwindigkeitsprofiles des Trägergases bewirkt.

Wenn die Kerne beschichtet sind, müssen sie aus dem Wirbelschichtofen entfernt werden. Bei den bekannten Öfen geschieht dies durch Absaugen dieser Kerne mittels einer Sauglanze oder durch Herausnehmen und Ausschütten des Reaktionsrohres. Allerdings ist es hierfür erforderlich, den Ofen teilweise zu demontieren, zumindest jedoch zunächst stark abzukühlen. Hierdurch entstehen ebenso Totzeiten wie durch das anschließende Aufheizen des Ofens für die nächste Charge. Außerdem ist dieser Entleervorgang mit erheblichen Wärme- und damit Energieverlusten verbunden.

Aus der FR-A-2 366 870 ist ein Wirbelschichtofen für die Beschichtung von Brennstoffkernen für Kernreaktoren bekannt, bei dem das Beschichtungsgas und das Träger- bzw. Schwebegas über getrennte Kanäle von unten in das Reaktionsrohr des Wirbelschichtofens geleitet wird. Dabei wird die Basis des Reaktionsrohres von einem konischen Teil der Zuführrohre gebildet, das das Reaktionsrohr beim Beschichtungsvorgang mechanisch abdichtet. Zum Entleeren werden die Zuführrohre abgesenkt, so daß an der Ofenbasis ein ringförmiger Spalt entsteht, durch den dann die beschichteten Brennstoffkerne nach unten in einen Ringkanal fallen können, der in ein Abzugrohr mündet.

Diese Art der Entleerung eines Wirbelschichtofens läßt sich nicht ohne weiteres auf einen Wirbelschichtofen der eingangs genannten Art übertragen, da die Absenkung des Zuführrohres allein wirkungslos bliebe, also nicht zu einem Herabfallen der Brennstoffkerne führen würde. Wird dagegen die Gaszufuhr gedrosselt, so besteht die Gefahr, daß die Brennstoffkerne in das Innenrohr hineinfallen.

Der Erfindung liegt die Aufgabe zugrunde, den Wirbelschichtofen der eingangs genannten Art so zu gestalten, daß er auch in heißem Zustand zügig und ohne Demontage von Ofenteilen entleert werden kann.

Diese Aufgabe wird erfindungsgemäß durch folgende Merkmale gelöst:

a)   das Innenrohr ist so weit absenkbar, daß an der porösen Platte ein Durchtritt für nach unten herabfallende Brennstoffkerne entsteht;

b)   in den Zwischenraum zwischen Außenrohr und Innenrohr ist eine Sammeleinrichtung zum Auffangen der Brennstoffkerne angeordnet;

c)   das Innenrohr ist von der Zuführung des Beschichtungsgases auf die Zuführung eines Inertgases umschaltbar;

d)   das Außenrohr ist an eine Überströmleitung mit einem Ventil zur Belüftung des Außenrohrs angeschlossen.

Aufgrund der durch diese Merkmale gekennzeichneten Gestaltung des gattungsgemäßen Wirbelschichtofen kann dessen Reaktionsrohr auf einfache Weise nach unten entleert werden. Das dabei zur Anwendung kommende Verfahren ist dadurch gekennzeichnet, daß nach einer der zu erstellenden Schichtdicke entsprechenden Beschichtungsdauer das Beschichtungsgas im Innenrohr durch ein Inertgas ersetzt und die Zuführung des Trägergases unterbrochen wird, daß dann das Innenrohr — gegebenenfalls zusammen mit einem Mantelrohr abgesenkt und daß schließlich der Intergasstrom derart abgelenkt wird, daß die Partikeln aus dem Reaktionsrohr unter Umgehung der Mündung des Innenrohres fallen. Dabei sorgt der aus dem Innenrohr kommende Inertgasstrom dafür, daß die herunterfallenden Kerne nicht in das Innenrohr gelangen, sondern in dem Zwischenraum verbleiben, wo sie von der Sammeleinrichtung aufgefangen werden. Über die Überströmleitung wird dann der Intergasstrom derart abgelenkt, daß die aerodynamischen Kräfte, die auf die im Reaktionsrohr befindlichen Brennstoffkerne wirken, stark verringert werden, ohne daß die Gefahr besteht, daß die dann herunterfallenden Kerne in das Innenrohr hineinfallen. Nach dem Abziehen wird das Innenrohr wieder hochgefahren und die Zufuhr des Trägergases wieder ausgeschaltet. Ist die neue Charge eingefüllt, so wird das aus dem Innenrohr kommende Intertgas wieder gegen das Beschichtungsgas in einem kontinuierlichen Übergang ausgetauscht.

In Ausbildung der Erfindung ist vorgesehen, daß das Innnerohr mit seinem oberen Ende bis unterhalb der ortsfest angebrachten porösen Platte absenkbar ist. Die Absenkung sollte dann so weit gehen, daß der laminare Gasstrom aus dem Innenrohr nicht die poröse Platte erreicht, damit die Brennstoffkerne ohne Schwierigkeiten durch die in der porösen Platte befindlichen Bohrung hindurchfallen können.

Nach der Erfindung ist ferner vorgeschlagen, daß das Innenrohr eine vorzugsweise kegelförmige Verdickung aufweist, mit der es in angehobener Stellung in der porösen Platte sitzt und die bei Absenkung des Innenrohres einen ringspaltenförmigen Durchtritt freigibt. Diese Ausbildung hat den Vorteil, daß das obere Ende des Innenrohres nicht bis weit unterhalb der porösen Platte abgesenkt werden muß, sondern nur so weit, bis die kegelförmige Verdickung den ringspaltenförmigen Durchtritt freigegeben hat.

Das gleiche Ziel kann auch dadurch erreicht werden, daß die poröse Platte an dem Innenrohr selbst befestigt und mit diesem absenkbar ist und daß das Außenrohr im Bereich der porösen Platte eine Erweiterung aufweist. Auf diese Weise entsteht zwischen dem Außenrand der porösen Platte und dem Außenrohr ein ringspaltförmiger Durchtritt, über den die beschichteten Brennstoffkerne nach unten fallen können.

Die Sammeleinrichtung kann beispielsweise aus einem den Zwischenraum ausfüllenden Auffangkörper mit einer schräg nach außen zu einem Abzugrohr führenden Auffangfläche ausgebildet sein, die vorzugsweise im Axialschnitt waagerecht verläuft. Durch die schräge Auffangfläche werden die Brennstoffkerne in das Abzugrohr geführt, wo sie in einem mit einem Intertgas gefüllten Behälter fallen.

Durch entsprechende Einstellung des Ventiles in der Überströmleitung kann die Geschwindigkeit des Entleervorganges gesteuert werden. Sofern ein Abzugrohr vorhanden ist, bietet es sich an, die Überströmleitung an dieses Abzugrohr anzuschließen.

In weiterer Ausbildung der Erfindung ist vorgesehen, daß das Innenrohr am Teil unterhalb der porösen Platte mit einem Mantelrohr mit obenseitigen Austritten versehen ist, wobei der Ringraum zwischen Mantelrohr und Innenrohr für die Zuführung des Trägergases in den Zwischenraum vorgesehen ist. Innenrohr und Mantelrohr bilden dabei eine absenkbare Einheit, die besonders kompakt ist und darüber hinaus ein problemloses Auffangen der Brennstoffkerne in dem Zwischenraum zuläßt. Zweckmäßigerweise sollten dabei die Austritte aus dem Mantelrohr mit einem porösen Ring versehen sein.

In der Zeichnung ist die Erfindung an Hand von Ausführungsbeispielen näher veranschaulicht. Es zeigt

Fig. 1 eine Anströmeinheit eines Wirbelschichtofens in Beschichtungsstellung;

Fig. 2 die Anströmeinheit gemäß Fig. 1 in Entleerstellung;

Fig. 3 den oberen Teil einer anderen Anströmeinheit eines Wirbelschichtofens in Beschichtungsstellung;

Fig. 4 den oberen Teil einer Anströmeinheit gemäß Fig. 3 in Entleerstellung;

Fig. 5 den oberen Teil einer weiteren Anströmeinheit eines Wirbelschichtofens in Beschichtungsstellung;

Fig. 6 den oberen Teil einer Anströmeinheit gemäß Fig. 5 in Entleerstellung.

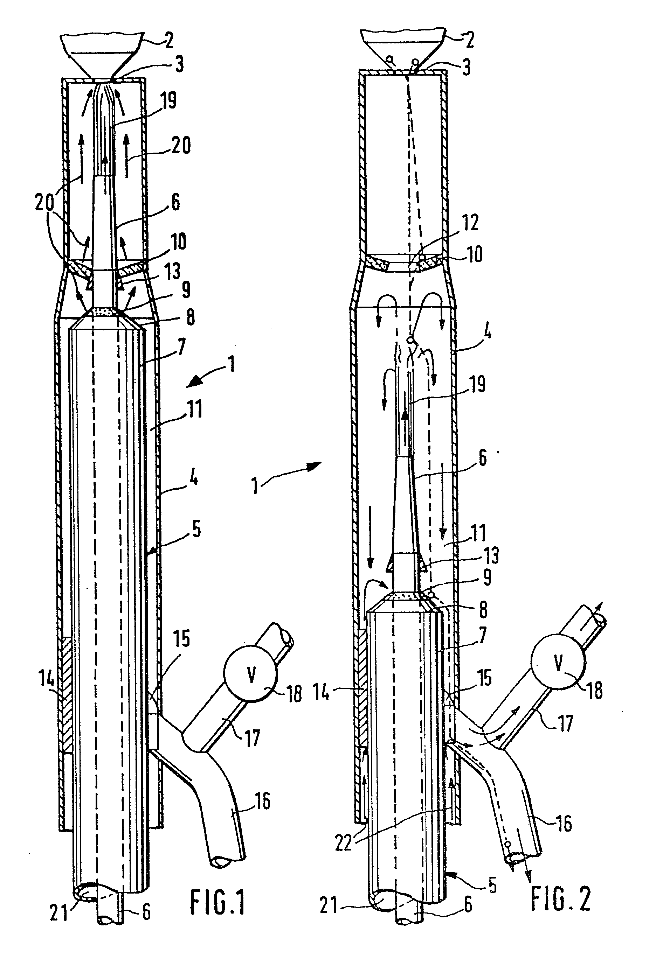

In allen Figuren haben gleiche oder funktionsgleiche Teile die selben Bezugsziffern. Der in den Fig. 1 und 2 gezeigte untere Teil eines Wirbelschichtofens besteht aus einer Anströmeinheit 1 und dem unteren Teil eines Reaktionsrohres 2, in das die Brennstoffkerne für den Beschichtungsvorgang eingefüllt werden. Das Reaktionsrohr 2 verjüngt sich zum unteren Ende hin und hat dort eine freie Blendenöffnung 3.

Die Anströmeinheit 1 weist ein Außenrohr 4 auf, das konzentrisch zur Blendenöffnung 3 angeordnet ist. In diesem Außenrohr 4 ist ebenfalls konzentrisch eine Gaszuführungslanze 5 eingesetzt, die in axialer Richtung beweglich ist. Sie besteht aus einem Innenrohr 6 und einem konzentrisch das Innenrohr 6 bis auf einen oberen Teil umgebende Mantelrohr 7. Das obere Ende 8 des Mantelrohres 7 verjüngt sich kegelförmig zum Innenrohr 6 hin und weist dort einen porösen Ring 9 auf. Die Mündung des Innenrohres 6 endet im Abstand zur Blendenöffnung 3.

Oberhalb des Endes 8 des Mantelrohres 7 ist eine poröse Platte 10 angeordnet, die den Zwischenraum 11 zwischen Innenrohr 6 bzw. Mantelrohr 7 und dem Außenrohr 4 abdeckt. Sie ist mit ihrem Außenrand am Außenrand 4 befestigt und kegelförmig nach innen geneigt. Zur Durchführung des Innenrohres 4 weist die poröse Platte 10 eine Bohrung 12 auf. Um dort einen dichten Sitz zu gewährleisten, ist das Innenrohr mit einem Kegelring 13 umgeben, der mit der entsprechend ausgebildeten Bohrung 12 korrespondiert.

Im unteren Bereich des Außenrohres 4 ist ein den Zwischenraum 11 ausfüllender Auffangkörper 14 angeordnet, dessen oberes Ende eine schraubenförmig ausgebildete Auffangfläche 15 aufweist. Deren unteres Ende mündet in ein Abzugsrohr 16 ein, das von dem Außenrohr 4 abzweigt. Von diesem Abzugsrohr 16 geht nach oben eine Überströmleitung 17 aus, die mit einem Ventil 18 versehen ist.

Die gezeigte Anströmeinheit 1 arbeitet wie folgt:

Fig. 1 zeigt die Anströmeinheit 1 in Beschichtungsstellung, d. h. die im Reaktionsrohr 2 eingefüllten Brennstoffkerne werden mittels eines Beschichtungsgases beschichtet. Dieses Beschichtungsgas wird in einem laminaren Zentralstrom 19 über das Innenrohr 6 durch die Blendenöffnung 3 geblasen und durchdringt dann das von den Brennstoffkernen gebildete Bett. Zusätzlich zu dem Beschichtungsgas wird ein Trägergas, symbolisiert durch die Pfeile 20, zugeführt, und zwar über den von Innenrohr 6 und Mantelrohr 7 gebildeten Ringraum 21. Dort strömt es über den porösen Ring 9 in den Zwischenraum 11, durchdringt die poröse Platte 10 und strömt dann weiter hoch, das Beschichtungsgas umhüllend in das Reaktionsrohr 2 ein, wobei die poröse Platte 10 für eine Vergleichmäßigung des Geschwindigkeitsprofiles sorgt. Im Reaktionsrohr 2 bewirkt das Trägergas eine Durchwirbelung der Brennstoffkerne. Dabei sind Trägergas und Beschichtungsgas hinsichtlich ihrer Strömungsgeschwindigkeit so eingestellt, daß die Brennstoffkerne in dem Reaktionsrohr 2 ohne weitere Unterstützung gehalten werden, die Balancegeschwindigkeit der Brennstoffkerne also nicht unterschritten wird.

Nach einer bestimmten Beschichtungsdauer, also nach Erreichen einer gewünschten Schichtdicke auf den Brennstoffkernen, wird das Beschichtungsgas durch Argon ersetzt. Der Argonstrom wird so eingestellt, daß dessen Geschwindigkeit über der Freifallgeschwindigkeit eines nicht beschichteten Brennstoffkernes liegt. Hierdurch wird vermieden, daß beim Entleeren des Reaktionsrohres 2 Partikeln oder Ruß in das Innenrohr 6 gelangen, sich dort festsetzen und beim nächsten Beschichtungsvorgang als Störkörper wirken.

Danach wird das Trägergas abgestellt. Der Argonstrom ist jedoch dann noch so groß, daß die Balancegeschwindigkeit der im Reaktionsrohr 2 befindlichen Brennstoffkerne noch nicht unterschritten wird, die Brennstoffkerne also noch dort verbleiben. Im Raum unterhalb der Blendenöffnung 3 herrscht also noch ein Druck, der dem Druckverlust der Blendenöffnung 3 und dem des Bettes aus Brennstoffkernen entspricht. Nun kann die Gaszuführungslanze 5 abgesenkt werden, wie dies in Fig. 2 gezeigt wird. Die Absenkung sollte dabei so weit gehen, daß der laminare Zentralstrahl 19 die Bohrung 12 in der porösen Platte 10 nicht mehr erreicht.

Für dem Entleervorgang wird nun das Ventil 18 in der Überströmleitung 17 geöffnet. Da der Druckverlust über die Überströmleitung 17 und das Ventil 18 geringer ist als der über die Blendenöffnung 3 und das Bett im Reaktionsrohr 2, wird der Argonstrom im wesentlichen über diese Überströmleitung 17 entweichen. Die im Reaktionsrohr 2 befindlichen Brennstoffkerne werden dann nicht mehr genügend angeströmt und fallen durch die Blendenöffnung 3 nach unten auf die poröse Platte 10. Dort rollen sie nach innen zu der Bohrung 12 und fallen dann weiter nach unten in den von Mantelrohr 7 und Außenrohr 4 gebildeten Teil des Zwischenraumes 11. Dort gelangen sie auf die Auffangfläche 15 des Auffangkörpers 14 und rollen dann in das Abzugsrohr 16 und gelangen dabei in einen mit Inertgas gefüllten, hier nicht gezeigten Auffangbehälter.

Um zu verhindern, daß sich zwischen der Gaszuführungslanze 5 und dem Auffangkörper 14 Ruß und eventuell Teilchen der Brennstoffkerne absetzen, die die Verschiebbarkeit des Gaszuführungslanze 5 beeinträchtigen könnten, wird ein Spülgas, symbolisiert durch die Pfeile 22, durch den Spalt zwischen Auffangkörper 14 und Gaszuführungslanze 5 gepreßt. Das Spülgas entweicht dabei ebenfalls durch die Überströmleitung 17.

Durch Verändern des Durchflußquerschnittes des Ventiles 18 in der Überströmleitung 17 kann der Druckverlust und damit die Anströmung des Bettes aus Brennstoffkernen variiert werden. Auf diese Weise läßt sich der Entleervorgang entsprechend den Bedürfnissen einstellen. Eine entsprechende Beeinflussung läßt sich auch dadurch erzielen, daß das Trägergas nicht völlig abgeschaltet wird. Dies empfiehlt sich dann, wenn der Volumenstrom des Zentralstrahles 19 nicht ausreicht, um die Brennstoffkerne vor dem Absenken der Gaszuführungslanze 5 in dem Reaktionsrohr 2 zu halten.

Ist der Entladevorgang abgeschlossen, wird das Ventil 18 in der Überströmleitung 17 geschlossen und die Gaszuführungslanze 5 wieder in die Beschichtungsstellung nach Fig. 1 hochgefahren. Das Reaktionsrohr 2 kann dann wieder mit einer neuen Charge Brennstoffkerne gefüllt werden. Das Trägergas wird wieder angeschaltet und der Argonstrom im Innenrohr 6 durch das Beschichtungsgas ersetzt, so daß ein neuer Beschichtungsvorgang beginnen kann.

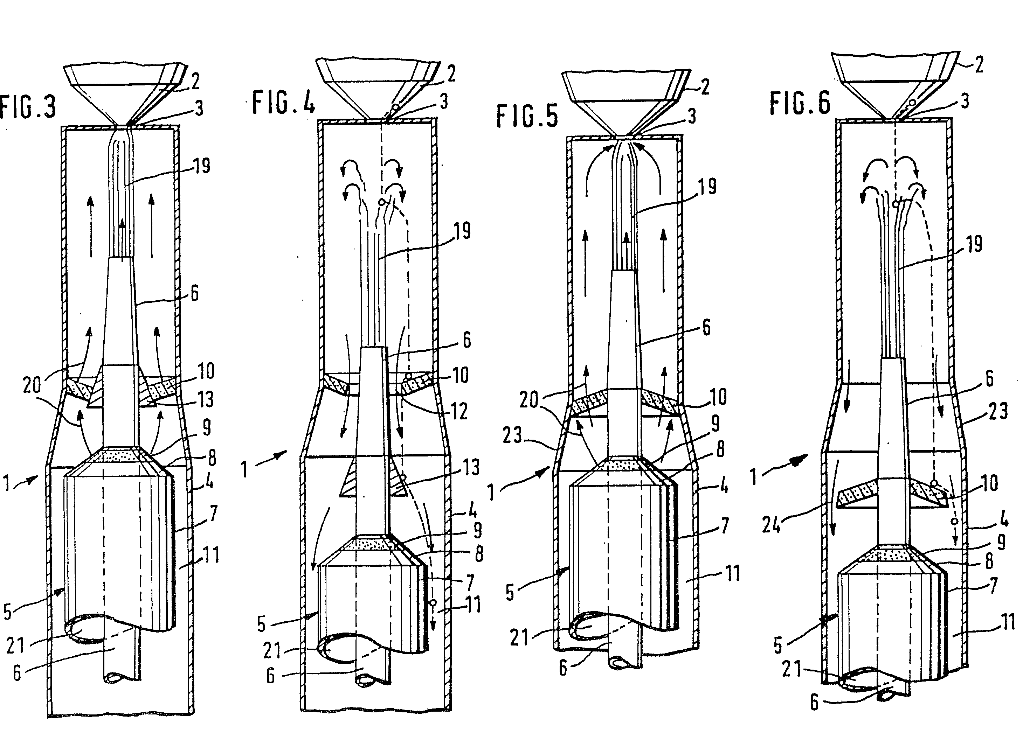

Die Fig. 3 und 4 zeigen den oberen Teil einer modifizierten Ausführungsform einer Anströmeinheit 1, und zwar Fig. 3 in der Beschichtungsstellung und Fig. 4 in der Entleerstellung.

Die einzige Änderung gegenüber der Ausführungsform nach den Fig. 1 und 2 betrifft den Kegelring 13, der hier so stark ausgebildet ist, daß er beim Absenken der Gaszuführungslanze 5 einen derart großen Querschnitt in der Bohrung 12 der porösen Platte 10 freigibt, daß die beim Entleeren aus dem Reaktionsrohr 2 fallenden Brennstoffkerne über diesen Querschnitt weiter nach unten gelangen können, obwohl das obere Ende des Innenrohres 6 noch in der Bohrung 13 sitzt (vgl. Fig. 4). Dies hat den Vorteil, daß die Gaszuführungslanze 5 nicht so weit wie bei der Ausführungsform nach den Fig. 1 und 2 nach unten abgesenkt werden braucht. Hierdurch wird Bauhöhe gespart.

Ansonsten ist die Anströmeinheit 1 mit der in den Fig. 1 und 2 gezeigten identisch, und zwar auch was die hier nicht gezeigten Teile angeht.

Die Fig. 5 und 6 zeigen eine weitere Ausführungsform der Anströmeinheit 1 des Wirbelschichtofens, und zwar hier auch nur deren oberen Teil.

Die einzige Änderung gegenüber den in den vorhergehenden Figuren gezeigten Ausführungsformen besteht darin, daß das Innenrohr 6 der Gaszuführungslanze 5 keinen Kegelring mehr trägt, sondern an dem Innenrohr 6 selbst die poröse Platte 10 befestigt und ihr äußerer Rand vom Außenrohr 4 gelöst ist. Die poröse Platte 10 korrespondiert jetzt mit einer nach unten sich öffnenden, kegelförmigen Erweiterung 23 des Außenrohres 4, in deren Oberteil sie in der Beschichtungsstellung sitzt. Für die Entleerung wird die Gaszuführlanze 5 nach unten gefahren, so daß die am Innenrohr 6 befestigte Platte 10 in den erweiterten Bereich des Außenrohres 4 gelangt und sich deshalb ein ringförmiger Spalt 24 für die Brennstoffkerne bildet. Durch die kegelförmige Ausbildung der porösen Platte 10 rollen die Brennstoffkörper nach außen durch diesen Spalt 24 und fallen dann herunter, wo sie von dem hier nicht dargestellten Auffangkörper in das Abzugrohr geleitet werden.

Auch diese Ausführungsform hat den Vorteil, daß die Gaszuführungslanze 5 nur geringfügig abgesenkt werden muß, um den Durchtritt für die Brennstoffkerne im Bereich der porösen Platte 10 zu ermöglichen. Ansonsten entspricht diese Anströmeinheit 1 den in den vorhergehenden Figuren gezeigten Ausführungsformen.

**Patentansprüche**

1. Wirbelschichtofen für die Beschichtung von Brennstoffkernen für Kernreaktoren, insbesondere von HTR-Brennstoffkernen, mit einem Reaktionsrohr zur Aufnahme der Kerne, dessen unteres Ende wenigstens eine Blendenöffnung aufweist, sowie mit einem sich nach unten anschließenden Außenrohr und wenigstens einem in diesem unterhalb jeder Blendenöffnung angeordneten, axial verschiebbaren Innenrohr, wobei in dem Zwischenraum zwischen Außenrohr und Innenrohr eine poröse Platte angeordnet ist sowie der Zwischenraum für die Zuführung eines Trägergases und das Innenrohr für die Zuführung eines Beschichtungsgases vorgesehen ist, gekennzeichnet durch die folgenden Merkmale:

a) das Innenrohr (6) ist so weit absenkbar, daß an der porösen Platte (10) ein Durchtritt (12, 24) für nach unten herabfallende Brennstoffkerne entsteht;

b) in den Zwischenraum (11) ist eine Sammeleinrichtung (14) zum Auffangen der Kerne angeordnet;

c) das Innenrohr (6) ist von der Zuführung des Beschichtungsgases auf die Zuführung eines Inertgases umschaltbar;

d) das Rohr (4) ist an eine Überströmleitung (17) mit einem Ventil (8) angeschlossen.

2. Wirbelschichtofen nach Anspruch 1, dadurch gekennzeichnet, daß das Innenrohr (6) mit seinem oberen Ende bis unterhalb der ortsfest angebrachten, porösen Platte (10) absenkbar ist.

3. Wirbelschichtofen nach Anspruch 2, dadurch gekennzeichnet, daß das Innenrohr (6) derart weit absenkbar ist, daß der Gasstrom (19) aus dem Innenrohr (6) nicht die poröse Platte (10) erreicht.

4. Wirbelschichtofen nach Anspruch 1, dadurch gekennzeichnet, daß das Innenrohr (6) eine vorzugsweise kegelförmige Verdickung (13) aufweist, mit der es in angehobener Stellung in der porösen Platte (10) sitzt und die bei Absenkung des Innenrohres (6) einen ringspaltförmigen Durchtritt (12) freigibt.

5. Wirbelschichtofen nach Anspruch 1, dadurch gekennzeichnet, daß die poröse Platte (10) an dem Innenrohr (6) befestigt und mit diesem absenkbar ist und daß das Außenrohr (4) im Bereich der porösen Platte (10) eine Erweiterung (23) aufweist.

6. Wirbelschichtofen nach einem der Ansprüche 1 bis 5, dadurch gekennzeichnet, daß die Sammeleinrichtung aus einem den Zwischenraum ausfüllenden Auffangkörper (14) mit einer schräg nach außen zu einem Abzugrohr (16) führenden Auffangfläche (15) ausgebildet ist.

7. Wirbelschichtofen nach Anspruch 6, dadurch gekennzeichnet, daß die Überströmleitung (17) von dem Abzugsrohr (16) abzweigt.

8. Wirbelschichtofen nach einem der Ansprüche 1 bis 7, dadurch gekennzeichnet, daß das Innenrohr (6) am Teil unterhalb der porösen Platte (10) von einem Mantelrohr (7) mit obenseitigen Austritten (9) versehen ist, wobei der Ringraum (21) zwischen Mantelrohr (7) und Innenrohr (6) für die Zuführung des Trägergases in den Zwischenraum (11) vorgesehen ist.

9. Wirbelschichtofen nach Anspruch 8, dadurch gekennzeichnet, daß die Austritte mit einem porösen Ring (9) versehen sind.

10. Verfahren zum Entleeren eines Wirbelschichtofens nach einem der Ansprüche 1 bis 9, dadurch gekennzeichnet, daß nach einer der zu erstellenden Schichtdicke entsprechenden Beschichtungsdauer das Beschichtungsgas im Innenrohr (6) durch ein Inertgas ersetzt und die Zuführung des Trägergases unterbrochen wird, daß dann das Innenrohr (6) — gegebenenfalls zusammen mit dem Mantelrohr (7) — abgesenkt und daß schließlich der Intertgasstrom derart abgelenkt wird, daß die Partikeln aus dem Reaktionsrohr (2) unter Umgehung der Mündung des Innenrohres (6) fallen.

## Claims

1. A fluidized bed furnace for the coating of fuel cores for nuclear reactors, particularly of HTR fuel cores, with a reaction tube to receive the cores, the lower end of which comprises at least one diaphragm aperture, and with an outer tube comecting on below and at least one axially displaceable inner tube which is disposed in this below each diaphragm aperture, a porous plate being disposed in the gap between outer tube and inner tube, and the gap being provided for the supply of a carrier gas and the inner tube being provided for the supply of a coating gas, characterised by the following features:

a) the inner tube (6) can be lowered so far that a passage (12, 24) for fuel cores falling down is formed on the porous plate (10);

b) a collecting device (14) to intercept the cores is disposed in the gap (11);

c) the inner tube (6) can be switched over from supplying the coating gas to supplying an inert gas;

d) the tube (4) is connected to an overflow pipe (17) with a valve (18).

2. A fluidized bed furnace as claimed in claim 1, characterised in that the inner tube (6) can be lowered until its upper end is below the stationarily mounted porous plate (10).

3. A fluidized bed furnace as claimed in claim 2, characterised in that the inner tube (6) can be lowered so far that the stream of gas (19) from the inner tube (6) does not reach the porous plate (10).

4. A fluidized bed furnace as claimed in claim 1, characterised in that the inner tube (6) comprises a thickened portion (13) which is preferably tapered and with which, in the raised position, it sits in the porous plate (10) and which frees a passage (12) in the form of an annular gap when the inner tube (6) is lowered.

5. A fluidized bed furnace as claimed in claim 1, characterised in that the porous plate (10) is secured to the inner tube (6) and can be lowered with this and that the outer tube (4) comprises a widened portion (23) in the region of the porous plate (10).

6. A fluidized bed furnace as claimed in one of the claims 1 to 5, characterised in that the collecting device is constructed from an intercepting member (14) filling in the gap with an intercepting surface (15) leading obliquely outwards to a discharge pipe (16).

7. A fluidized bed furnance as claimed in claim 6, characterised in that the overflow pipe (17) branches off from the discharge pipe (16).

8. A fluidized bed furnace as claimed in one of the claims 1 to 7, characterised in that the inner tube (6) is provided, at the part below the porous plate (10), with a casing (7) with outlets (9) at the top, the annular space (21) between casing (7) and inner tube (6) being provided for the supply of the carrier gas to the gap (11).

9. A fluidized bed furnace as claimed in claim 8, characterised in that the outlets are provided with a porous ring (9).

10. A method of emptying a fluidized bed furnace as claimed in one of the claims 1 to 9, characterised in that after a coating period corresponding to the thickness of layer to be provided, the coating gas in the inner tube (6) is replaced by an inert gas and the supply of carrier gas is interrupted, that then the inner tube (6) — possibly together with the casing (7) — is lowered and that finally the stream of inert gas is deflected in such a manner that the particles fall out of the reaction tube (2) by-passing the mouth of the inner tube (6).

## Revendications

1. Four à lit fluidisé pour l'enrobage de noyaux de matière combustible pour des réacteurs nucléaires, notamment de noyaux de matière combustible pour réacteur à haute température, comprenant un tube de réaction, servant à recevoir les noyaux et dont l'extrémité inférieure présente au moins une ouverture à diaphragme, ainsi qu'un tube extérieur se raccordant vers le bas et au moins un tube intérieur pouvant coulisser axialement et disposé en-dessous de chaque ouverture à diaphragme, une plaque poreuse étant interposée dans l'espace intermédiaire compris entre le tube extérieur et le tube intérieur, l'espace intermédiaire étant prévu pour l'amenée d'un gaz porteur et le tube intérieur pour l'amenée d'un gaz d'enrobage, remarquable par les caractéristiques suivantes:

a) le tube intérieur (6) peut être abaissé si bas qu'il se forme sur la plaque poreuse (10) un passage (12, 24) pour des noyaux de matière combustible qui tombent;

b) dans l'espace intermédiaire (11) est disposé un dispositif collecteur destiné à capter les noyaux;

c) le tube intérieur (6) peut être commuté pour passer d'une position dans laquelle il sert à amener du gaz d'enrobage à une position dans laquelle il sert à amener un gaz inerte;

d) le tube (4) est raccordé à une vanne (18) par l'intermédiaire d'un conduit de débordement.

2. Four à lit fluidisé suivant la revendication 1, caractérisé en ce que l'extrémité supérieure du tube intérieur (6) peut être abaissée jusqu'en-dessous de la plaque poreuse (10) qui est montée fixe.

3. Four à lit fluidisé suivant la revendication 2, caractérisé en ce que le tube intérieur (6) peut être abaissé si bas que le courant gazeux (19) sortant du tube intérieur (6) n'atteint pas la plaque poreuse (10).

4. Four à lit fluidisé suivant la revendication 2, caractérisé en ce que le tube intérieur (6) présente une partie épaissie (13), de préférence conique, par laquelle il vient, en position relevée, dans la plaque (10) poreuse et qui, lorsque le tube intérieur (6) est abaissé, dégage un passage (12) en forme de fente annulaire.

5. Four à lit fluidisé suivant la revendication 1, caractérisé en ce que la plaque poreuse (10) est fixée au tube intérieur (6) et peut être abaissée avec celui-ci, et en ce que le tube extérieur (4) présente un évasement (23) dans la région de la plaque poreuse (10).

6. Four à lit fluidisé suivant l'une des revendications 1 à 5, caractérisé en ce que le dispositif collecteur est formé d'un corps de captage (14) remplissant l'espace intermédiaire, et ayant une surface de captage (15) inclinées vers l'extérieur menant à un tube d'évacuation (16).

7. Four à lit fluidisé suivant la revendication 6, caractérisé en ce que le conduit de débordement (17) est en dérivation du conduit d'évacuation (16).

8. Four à lit fluidisé suivant l'une des revendications 1 à 7, caractérisé en ce que le tube intérieur (6) est muni, à la partie se trouvant endessous de la plaque poreuse (10), d'un tube formant enveloppe (7) ayant des sorties (9) du côté supérieur, l'espace annulaire (21), compris entre le tube formant enveloppe (7) et le tube intérieur (6), étant prévu pour l'amenée du gaz porteur dans l'espace intermédiaire (11).

9. Four à lit fluidisé suivant la revendication 8, caractérisé en ce que les sorties sont munies d'une bague poreuse (9).

10. Procédé pour vider un four à lit fluidisé suivant l'une des revendications 1 à 9, caractérisé en ce qu'il consiste à remplacer, après une durée d'enrobage correspondant à l'épaisseur d'enrobage à réaliser, le gaz d'enrobage dans le conduit intérieur (6) par un gaz inerte, et à interrompre l'amenée du gaz porteur, puis à abaisser le tube intérieur (6) — le cas échéant, en même temps que le tube formant enveloppe (7) — et, enfin, à détourner le courant de gaz inerte de manière à ce que les particules tombent du tube de réaction (2) en contournant l'embouchure de tube intérieur (6).

FIG.1

FIG. 2

FIG.3  FIG.4  FIG.5  FIG.6

0 041 259